# EUROPEAN PATENT APPLICATION

(11) **EP 0 771 023 A2**
(43) Date of publication of application: **02.05.1997**
(21) Application number: 96116977.8
(22) Date of filing: 23.10.1996
(51) Int. Cl.: H01L 21/56

(54) **Method of applying a protective coating on a semiconductor integrated circuit**

(30) Priority: 27.10.1995 US 549349; 27.10.1995 US 549350; 27.10.1995 US 549351
(71) Applicant: HONEYWELL INC., Minneapolis Minnesota 55408 (US)
(72) Inventor: Heffner, Kenneth H., Largo, FL 34648 (US); Anderson, Curtis W., Largo, FL 34648 (US)
(74) Representative: Herzbach, Dieter, Dipl.-Ing.

(57) **Abstract**

Particles of a coating composition (33), selected to provide a security or protective coating (28), are heated in a flame spray (34) to molten state and sprayed on an integrated circuit (10) in successive passives to build a desired thickness coating on the circuit. The particles are selected to have a size such that they remain molten when impacting the circuit but do not damage the circuit. The flame spray is held at a distance from the circuit that holds the particles in the molten state but produces minimal circuit heating. The coating composition is selected from materials that are opaque to visible light, attenuate electromagnetic and radiation energy and are conductive or semiconductive.

## Description

This invention relates to techniques for applying security and protective coatings to electronic circuits.

Opaque coatings and methods of applying opaque coatings to electronic devices to inhibit inspection and reverse engineering are generally known. US-A-5,399,441 discloses one such method of forming an opaque coating on an integrated circuit. There an opaque ceramic coating is formed on an integrated circuit by a process which includes selectively applying a coating composition comprising a silica precursor resin and a filler onto the surface of the integrated circuit. A liquid mixture that includes the silica precursor resin and the filler is selectively applied to the integrated circuit by (1) masking the circuit, applying the liquid mixture and removing the mask, (2) selectively "painting" the circuit or (3) silk screening the circuit.

The coated integrated circuit is then heated at a temperature sufficient to convert the coating composition (i.e., liquid mixture) to a silica containing ceramic matrix having the filler distributed therein. Preferably, the integrated circuit with coating composition thereon is heated in a Lindberg furnace at a temperature within the range of about 50°C to 425°C for generally up to six (6) hours, with less than about three (3) hours being preferred, to convert the coating composition to a silica containing ceramic matrix. In the known method the preferred silica precursor resin is hydrogen silsesquioxane resin (H-resin). To achieve a coating opaque to radiation, a filler comprising insoluble salts of heavy metals is combined with the silica precursor resin. To achieve a coating impenetrable to visual light, an optically opaque filler is combined with the silica precursor resin.

Because the method of applying the opaque coating to an integrated circuit of this known method requires an extensive heating time period to transform the coating composition to a silica containing ceramic matrix, this method is not particularly cost effective or efficient on a mass production level.

US-A-5,258,334 discloses another process of applying an opaque ceramic coating to an integrated circuit. There visual access to the topology of an integrated circuit is denied via an opaque ceramic produced by first mixing opaque particulate with a silica precursor. This mixture is then applied to the surface of the integrated circuit. The coated integrated circuit is then heated to a temperature in the range of 50°C to 450°C in an inert environment for a time within the range of one (1) second to six (6) hours to allow the coating to flow across the surface of the integrated circuit without ceramifying. The coated integrated circuit is then heated to a temperature in the range of 20°C to 1000°C in a reactive environment for a time in the range of two (2) to twelve (12) hours to allow the coating to ceramify. As with the above described patent, the method of applying the opaque coating is time consuming and therefore not particularly cost effective or efficient on a mass production level.

There is a need for improved protective coatings for integrated circuits and multichip modules. In particular, there is a need for an improved protective coating that is both radiopaque and optically opaque to prevent inspection and/or reverse engineering of the topology of the integrated circuits and multichip modules. The protective coating should be capable of being applied to integrated circuits and multichip modules in a time efficient and cost effective process to permit coating application on a mass production level.

An object of the invention is to provide a method for applying thermal coatings to integrated circuits in a way that does not damage the circuit elements and connections so that multilayers of coatings can be applied to make such circuits resistant to inspection (reverse engineering) and damage from electromagnetic energy and radiation.

This object is achieved by the characterizing features of claim 1. Further advantageous embodiments of the invention may be taken from the dependent claims.

According to the invention, coating composition particles are selected so that they can enter a molten state in a flame spray and impact the circuit without causing damage to the circuit components. If the particles are too large they will damage the circuit. If they are too small they will cool too quickly and the coating will be imperfect. The flame spray with the molten particles is passed over the circuit at a distance at which the particles are still molten but heating to the circuit is at a safe level. Successive passes are made, building up the coating layer.

According to the invention, the coating materials are selected that absorb different electromagnetic frequencies, such as visible light and X-rays, the layers are built-up to a thickness that provides a desired level of attenuation.

According to the invention, a coating composition of a radiation resistant material is built-up to a thickness that protects the circuit from the damaging effects of the radiation.

A feature of the invention is that, by applying layers of different coatings, the circuit can be protected from reverse engineering as well as damage from external energy sources.

Another feature of the invention is that the process can be performed quickly on small circuits yet without damaging the delicate components, and the thickness of the coatings are uniform along the circuit.

A feature of the invention is that the protective coating can be applied to semiconductor integrated circuit devices, such as integrated circuits and multichip modules, in a time efficient and cost effective process to permit coating application on a mass production level.

Other objects, benefits and features of the invention will be apparent from the following description of the invention and the drawings.

### BRIEF DESCRIPTION OF THE DRAWINGS

FIG. 1 is a sectional view of an integrated circuit or multichip module prior to the application of a protective opaque coating in accordance with the present invention.

FIG. 2 is a schematic elevational view of the protective opaque coating being applied to the integrated circuit or multichip module shown in FIG. 1.

FIG. 3 is a sectional view similar to FIG. 1 of the integrated circuit or multichip module with the protective opaque coating applied thereto according to the invention.

FIG. 4 is also sectional view similar to FIG. 1 of the integrated circuit or multichip module having an opaque coating and energy protective coating applied according to the invention.

### BEST MODE FOR CARRYING OUT THE INVENTION

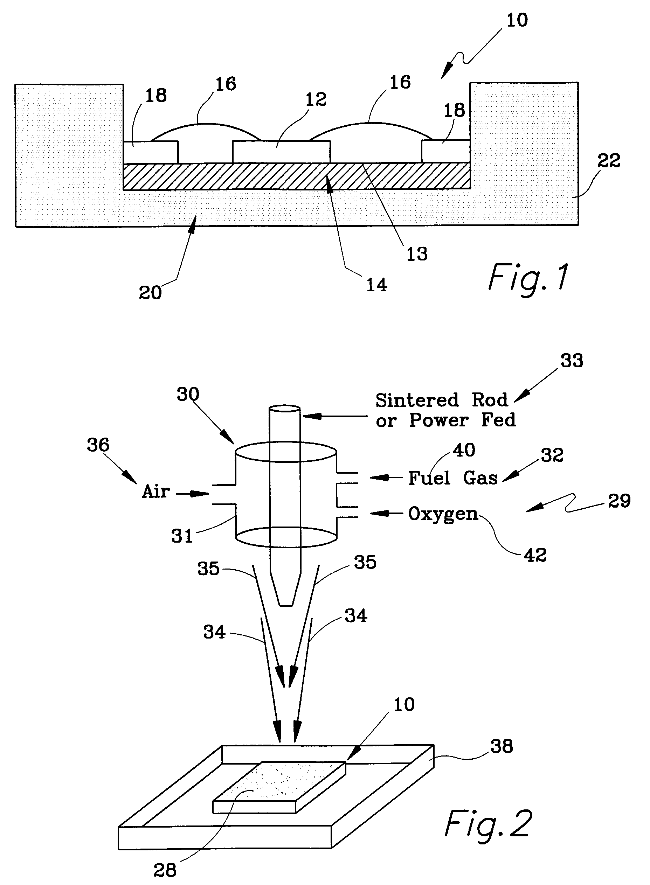

A semiconductor integrated circuit device, such as an integrated circuit (IC) or multichip module (MCM) 10 to be coated in accordance with the present invention is illustrated generally in FIG. 1. The IC or MCM 10 includes a single, active circuitry semiconductor chip 12 (in the case of an IC) or multiple, active circuitry semiconductor chips 12 (in the case of a MCM). The semiconductor chip(s) 12 is mounted on a surface 13 of a substrate 14 and includes lead wires 16 that are connected to pads 18 also mounted on the surface 13 of the substrate 14. The pads 18 serve as ports for electrical connection to external sources (not shown). The substrate 14 with the chip(s) 12 and pads 18 mounted thereto is housed within a ceramic package 20 defined by a base member 22, a lid member 24 and a lid seal 26 (the lid member 24 and lid seal 26 not being shown in FIG. 1.).

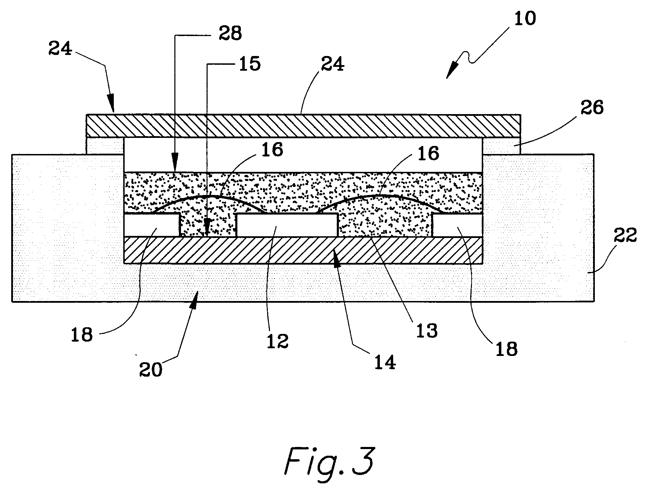

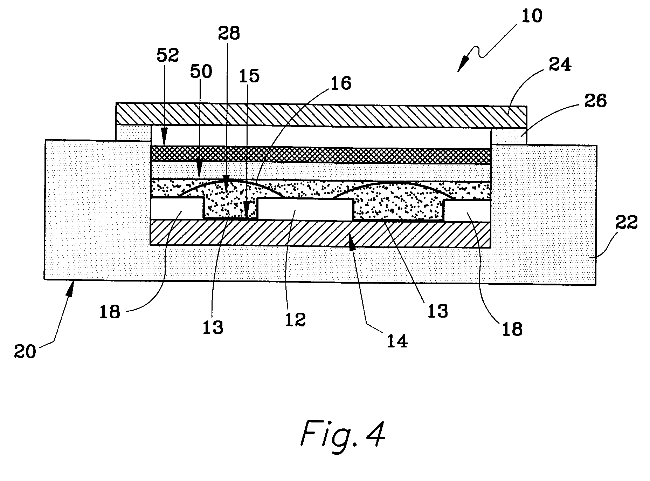

The IC or MCM 10 maybe coated with just a protective opaque coating 28 (see FIG. 3) by a thermal spray process 29, as illustrated in FIG. 3. On the other hand, as shown in Fig. 4., the circuit may be first prepared with a primer coating an organic based film, primer coating 15 applied by way of reactive vacuum deposition, thermal spray or liquid coating process. Before the primer coating 15 is applied, a primer coating composition that defines the primer coating 15 is prepared. The primer coating composition is prepared from chemical materials that are compatible with the materials from which the IC or MCM 10 is manufactured. In the present invention, the primer coating composition may be Parylene, a solid thermoplastic, a solid siloxane or a furfural based liquid polymer. In one preferred embodiment, the primer coating composition is Parylene. In another preferred embodiment, the primer coating composition is siloxane. Once prepared, the primer coating composition is applied to the IC or MCM 10 devices using reactive vacuum deposition for Parylene, thermal spray deposition for thermoplastic and siloxanes and liquid drop deposition for the furfural based polymer. As shown in FIG. 4, the formed primer coating 15 completely covers the semiconductor chip(s) 12, lead wires 16, pads 18 and the surface 13 of the substrate 14 housed within the base member 22. However, the primer 15 may be applied so as to only partially or completely cover any one of or more of the semiconductor chip(s) 12, leads 16, pads 18 and/or surface 13. In the present invention, once formed, the primer coating 15 has a thickness within the range of 0.1 mils to 2 mils. In one preferred embodiment, the formed primer coating 15 has a thickness of 0.7 mils. The primer coating 15 is applied before the protective opaque coating 28, to improve the resistance of the IC or MCM 10 to mechanical and/or thermal damage that may result from the molten liquefied particles 35 being driven toward the IC or MCM 10 (via carrier gas jet 36) and impacting the IC or MCM 10 at a high velocity. The primer coating 15 provides protection particularly when the IC or MCM 10 is electronically delicate. For example, when the IC or MCM 10 has thin lead wires 16, weak bonding joints between the lead wires 16 the pads 18 and semiconductor chip(s) 12, and/or when the circuit architecture of the IC or MCM 10 is susceptible to thermal shock or impingement damage.

After the primer coating 15 is applied and allowed to form (i.e., cure), the IC or MCM 10 is then coated with the protective opaque coating 28 (see FIG. 3) by a thermal spray process 29 illustrated in FIG. 2. The thermal spray process 29, of the present invention, is a line of sight coating process that includes a thermal spray gun 30 having a nozzle 31. A heat energy source 32 is delivered to the nozzle 31 (in a known manner) to heat a ceramic particle based coating composition 33 also delivered to the nozzle 31 (in a known manner). The heat energy source 32 uses a flame 34 to heat the coating composition 33 to a molten state defined by molten liquefied particles 35. The molten liquefied particles 35 defining the coating composition 33 are carried to the IC or MCM 10 by a carrier gas jet 36 also delivered to the nozzle 31 (in a known manner). The IC or MCM 10 is supported on a support element 38 that may act as heat sink during the coating process.

The thermal spray process 29 first requires the preparation of the ceramic particle based coating composition 33. It is desirable that the chemistry of the coating composition 33 be similar to the chemistry of the materials of the IC or MCM 10, such that attempted removal of the protective opaque coating 28 (formed from the coating composition 33) from the IC or MCM 10 (for inspection and/or reverse engineering of the topology of the IC or MCM) via chemical methods will simultaneously destroy the IC or MCM 10. In the present invention, the coating composition 33 may be a single chemical component or a multi chemical component composition, partially or entirely formed from any one of alumina, beryllia, silica, silicon carbide, aluminum nitride, fused alumina-titanium oxide, fused alumina-titanium dioxide and nylon or alumina-titanium oxide and Teflon. In one preferred embodiment fused alumina-titanium oxide was found to provide a desirable coating composition 33 for the protective opaque coating 28.

The coating composition 33 is prepared by manufacturing the chemical materials of the coating composition 33 into a powder or sintered rod having particle sizes within the range of ten microns to sixty microns. Particle sizes in excess of sixty microns tend to cause mechanical damage to the IC or MCM 10 due to that force at which the carrier gas jet 36 delivers the molten liquefied particles 35 to the IC or MCM 10. Particle sizes less than ten microns tend to cause transformation of the particle based coating composition 33 into a liquid stream (rather than molten liquefied particles 35) that may be difficult to control during the application process. In one preferred embodiment, a coating composition 33 prepared in the form of a sintered rod with the coating composition 33 having a particle size within the range of ten microns to twenty microns is desirable.

Once the coating composition 33 is prepared, the coating composition 33, the heat energy source 32 and the carrier gas jet 36 are simultaneously delivered to the nozzle 31 of the thermal spray gun 30. The heat energy source 32 can take the form of a plasma arc, an electric arc or a fuel gas. In one preferred embodiment, the heat energy source is a fuel gas 40 (preferably acetylene) which is combined with oxygen 42 to create that flame 34 that is of a temperature sufficient to transform the ceramic particle based coating composition 33 to molten liquefied particles 35. In one preferred embodiment, this temperature is in the range of between 200°C and 1500°C. The molten liquefied particles 35 are applied to the IC or MCM 10 via the carrier gas jet 36 which carries the molten liquefied particles 35 to the IC or MCM 10 and causes the particles 35 to impact upon the IC or MCM 10. The molten liquefied particles 35 undergo a "splat" upon impact with the surface of the IC or MCM 10, and then coalesce to form a contiguous coating that thickens with continued successive depositions of the molten liquefied particles 35 to form the lamellar protective opaque coating 28. In one preferred embodiment, the carrier gas jet 36 is pressurized air which is delivered to the nozzle 31 of the thermal spray gun 30 at approximately 100 cfm.

As seen in FIG. 2, in practice, the nozzle 31 of the thermal spray gun 30 is positioned above the IC or MCM 10 which is held in place by the support element 38 which can draw heat away from the IC or MCM 10 during the application process. Typically, the nozzle 31 is positioned from the IC or MCM 10 within the range of between five inches and seven inches. In one preferred embodiment, the nozzle 31 is positioned six inches from the IC or MCM 10. The molten liquefied particles 35 can be applied in successive layers or as a single burst depending upon the desired coating thickness and the thermal limitations of the IC or MCM 10. In one preferred embodiment, the thickness of the formed protective coating 28 is in the range of between 1 to 100 mils. The molten liquefied particles 35 are applied by moving the nozzle 31 of the thermal spray gun 30 back and forth over the surface of the IC or MCM 10, by moving the IC or MCM 10 relative to the nozzle 31, or by moving both the nozzle 31 and the IC or MCM 10 relative to one another. In one preferred embodiment, the nozzle 31 is moved relative to a stationary IC or MCM 10.

Once the molten liquefied particles 35 are applied, they form a lamellar protective opaque coating that adhesively bonds to the surface of the IC or MCM 10 and is abrasion resistant, provides a hermetic seal, and prevents both active and passive, chemical, optical and radiation based inspection and/or reverse engineering of the active and inactive circuitry of the IC or MCM 10. As seen in FIG. 3, the formed protective opaque coating 28 completely covers the semiconductor chip(s) 12, lead wires 16, pads 18 and the surface 13 of the substrate 14 housed within the base member 22. However, the protective, opaque coating 28 may be applied so as to only partially or completely cover any one of or more of the semiconductor chip(s) 12, leads 16, pads 18 and/or surface 13. Once the protective opaque coating 28 is formed, the lid seal 26 and the lid member 24 are mounted on the base member 22 to further hermetically seal the IC or MCM 10.

The molten liquefied particles 35 can be applied to the surface of the IC or MCM 10 (to achieve complete coverage as shown in FIG. 3) in 15 to 600 seconds. The protective opaque coating 28 can be fully cured and cooled and the IC or MCM 10 ready for use in only 1 to 70 minutes. Therefore, the thermal spray process is capable of producing inspection and/or reverse engineering proof IC's or MCM's 10 in a time efficient and cost effective manner that permits coating application on a mass production level.

Fig. 4 shows another application for the invention. Once the opaque coating 28 is formed (i.e., cured), the IC or MCM 10 is then coated with a radiation hardening coating 50 and/or a electromagnetic interference (EMI) hardening coating 52. Both the radiation hardening coating 50 and the EMI hardening coating 52 are shown as having been used in FIG. 3. However, it is to be understood that only one or the other of the coatings 50 and 52 may be used, and that EMI coating 52 may be applied before the radiation coating 50. The radiation hardening coating 50 shields the IC or MCM 10 (i.e., active circuitry) from the adverse affects of high energy radiation, while the EMI hardening coating 52 shields the IC or MCM 10 (i.e., active circuitry) from the adverse affects of EMI.

As with the opaque coating 28, both of the coatings 50 and 52 are formed from ceramic particle based coating compositions that have a chemistry similar to the chemistry of the materials of the IC or MCM 10, such that attempted removal of the coatings 50, 52, 28 and 15 (if used) from the IC or MCM 10 (for inspection and/or reverse engineering of the topology of the IC or MCM) via chemical methods will simultaneously destroy the IC or MCM 10. As with the coating composition 33, the coating compositions from which the coatings 50 and 52 may be a single chemical component or a multi chemical component compositions. The composition of the radiation coating 50 may be any one of barium titanate, lead oxide, tungsten carbide, bismuth oxide or other heavy metal compounds. In one preferred embodiment, barium titanate was found to provide a desirable composition for the radiation coating 50. The composition of the EMI coating 52 may be any one of titanium monoxide, chromium carbide, zinc, copper or other conductive metals. In one preferred embodiment, titanium monoxide was found to provide a desirable composition for the EMI coating 52.

Since the coating compositions of the coatings 50 and 52 are ceramic particle based like the coating composition 33 of the opaque coating 28, each coating 50 and 52 can be applied by the thermal spray process 29 (parameters and technique) discussed above, with the form of the compositions for the coatings 50 and 52 (e.g., sintered rod), particle size ranges (i.e., ten to sixty microns with 10 to twenty microns being preferred), application temperature range (i.e., 200°C to 3000°C), etc., being applicable.

As seen in FIG. 4, the formed EMI coating 52 and the formed radiation coating 50 completely cover the opaque coating 28 the primer coating 15 (if used), semiconductor chip(s) 12, lead wires 16, pads 18 and the surface 13 of the substrate 14 housed within the base member 22. However, the EMI coating 52 and the radiation coating 50 may be applied so as to only partially or completely cover any one of or more of the opaque coating 28, the primer coating 15 (if used), semiconductor chip(s) 12, leads 16, pads 18 and/or surface 13. In the present invention, once formed, the primer coating 15 has a thickness within the range of 0.1 mils to 2 mils. In one preferred embodiment, the thickness of each of the formed coatings 50 and 52 is in the range of between 0.1 mil and 200 mils.

The primer coating composition can be applied and cured to the primer coating 15 (to achieve complete coverage as shown in FIG. 4) in 1 to 60 minutes. The molten liquefied particles 35 can be applied and formed over the primer coating 15 on the surface of the IC or MCM 10 (to achieve complete coverage as shown in FIG. 3) in 15 to 600 seconds. The radiation coating 50 can be applied and formed over the opaque coating 28 (to achieve complete coverage as shown in FIG. 3) in 15 to 600 seconds. The EMI coating 52 can be applied and formed over the radiation coating 50 (to achieve complete coverage as shown in FIG. 3) in 15 to 600 seconds. The multiple layers of coating can be fully applied and cooled and the IC or MCM 10 ready for use in only 2 to 80 minutes. Therefore, the thermal spray process is capable of producing inspection and/or reverse engineering proof IC's or MCM's 10 in a time efficient and cost effective manner that permits coating application on a mass production level.

Although the present invention has been described with reference to preferred embodiments one of ordinary skill in the art will be able to make modifications and changes, in addition to any already described, in whole or in part to the components and devices described above to carry out the invention without departing from the spirit and scope of the invention.

## Claims

1. A method of forming a coating on a semiconductor integrated circuit device characterized by the steps :
preparing particles of a first coating composition;
injecting the first particles into a flame stream for transforming the first particles to a molten state; and
passing the flame stream over the surface of a semiconductor integrated circuit device in successive passes to build a desired thickness layer of said first composition.

2. The method of claim 1, further characterized by:
preparing particles of a second coating composition;
injecting the particles into a flame stream for transforming the second particles to a molten state; and
passing the flame stream over the surface of a semiconductor integrated circuit device in successive passes to build a desired thickness of said second composition over said layer of said first composition.

3. The method of claim 1 or 2, further characterized in that the step of heating the coating composition to a temperature sufficient to transform the coating composition to a molten state includes the step of:
simultaneously delivering the coating composition, a fuel gas and oxygen to a nozzle of a thermal spray gun such that the combination of the fuel gas and the oxygen creates a flame capable of transforming the coating composition to molten liquefied particles.

4. The method of claim 1 or 2, further characterized in that the step of applying the molten coating composition to a surface of a semiconductor integrated circuit device includes the step of:
simultaneously delivering the coating composition and pressurized air to a nozzle of a thermal spray gun such that the pressurized air applies the molten coating composition to the surface of the semiconductor integrated circuit device.

5. The method of claim 1, wherein the first coating composition is selected from the group of Parylene, a solid thermoplastic, a solid siloxane and a furfural based liquid polymer.

6. The method of claim 1 or 2, further characterized in that the steps of heating the coating composition to a molten state and applying the molten coating composition includes the step of:
simultaneously moving the nozzle of the spray gun back and forth over the surface of the semiconductor integrated circuit device to apply the molten coating composition to the surface to thereby form a lamellar opaque coating that adhesively bonds to the surface of the semiconductor integrated circuit device and is abrasion resistant.

7. The method of claim 1 or 2, further characterized in that the steps of heating the coating composition to a molten state and applying the molten coating composition includes the step of:
simultaneously moving the semiconductor integrated circuit device relative to the nozzle of the spray gun to apply the molten coating composition to the surface of the semiconductor integrated circuit device to thereby form a lamellar opaque coating that adhesively bonds to the surface and is abrasion resistant.

8. The method of claim 3, further characterized in that the fuel gas is acetylene.

9. The method of claim 1 or 2, further characterized in that the coating composition is selected from the group of fused alumina-titanium oxide, fused alumina-titanium dioxide and nylon, and fused alumina-titanium oxide and Teflon.

10. The method of claim 9, further characterized in that the coating composition is fused alumina-titanium oxide having a particle size in the range of ten microns to sixty microns.

11. The method of claim 10, further characterized in that the particle size is within the range of ten microns to twenty microns.

12. The method of claim 1 or 2, further characterized in that the temperature of the flame stream is between 200°C and 1500°C.

13. The method of claim 1 or 2, further characterized in that said successive passes occur at a selected distance above the integrated circuit at which said first and second particles strike the integrated circuit in a molten state and the temperature elevation of the integrated circuit is below a selected temperature.

14. The method of claim 1 or 2, further characterized in that one coating of said first and second coating compositions comprises a material that attenuates energy above the visible spectrum and said one coating has a thickness on the integrated circuit selected to attenuate said energy to by a selected magnitude.

15. The method of claim 1 or 2, further characterized in that said one coating composition is selected from the group consisting of barium titanate, lead oxide, tungsten carbide, and bismuth oxide.

16. The method of claim 1 or 2, further characterized in that said one coating composition is selected from the group consisting of titanium monoxide, chromium carbide, zinc, and copper.

17. A semiconductor integrated circuit device (10), comprising: circuitry (12, 16, 18) on a surface of the semiconductor integrated circuit device (10); a coating (28) overlying the circuitry, the coating formed from molten particles sprayed in successive passes over the circuitry to provide a desired coating thickness.
